# EUROPÄISCHE PATENTSCHRIFT

(11) **EP 0 473 831 B1**
(45) Veröffentlichungstag und Bekanntmachung des Hinweises auf die Patenterteilung: **16.02.1994**
(21) Anmeldenummer: 90117232.0
(22) Anmeldetag: 06.09.1990
(51) Int. Cl.: H02H 7/122, H02M 3/335, G01R 19/165

(54) **Schaltnetzteil mit n einzeln strombegrenzten Ausgangskreisen**
Power supply with n separate current-limited outputs
Alimentation avec n sorties séparées, limitées en courant

(43) Veröffentlichungstag der Anmeldung: 11.03.1992
(73) Patentinhaber: Siemens Nixdorf Informationssysteme Aktiengesellschaft, 33102 Paderborn (DE)
(72) Erfinder: Adam, Jürgen, Dipl.-Ing., D-8872 Burgau (DE); Schwarz, Karl, Dipl.-Ing., D-8908 Krumbach (DE)
(74) Vertreter: Fuchs, Franz-Josef, Dr.-Ing.

(56) Entgegenhaltungen:
- EP-A- 0 027 847
- DE-A- 3 732 334
- US-A- 4 626 953
- ELEKTRONIK. no. 9, 27 April 1990, MUNCHEN DE Seiten 158 - 166; M. Jung: "Durchflusswandler-Schaltnetzteil für 200 Watt."

## Beschreibung

Die Erfindung betrifft ein Schaltnetzteil mit n einzeln strombegrenzten Ausgangskreisen gemäß dem Oberbegriff des Anspruches 1.

Verschiedene Sicherheitsvorschriften schreiben bei Stromversorgungen, die im Zugriffsbereich von Benutzern liegen, eine Leistungsbegrenzung an den einzelnen Spannungsausgängen vor. Eine Überwachung der Spannungsausgänge auf Einhaltung eines maximalen Ausgangsstromes ist deshalb notwendig.

Eine Überwachung der Ausgangsströme kann beispielsweise dadurch erfolgen, daß der im Primärstromkreis fließende Strom erfaßt und auf Einhaltung eines Maximalwertes geprüft wird. Da der Primärstrom von der Summe der einzelnen Ausgangsströme, also auch von dem einzelnen Ausgangsstrom, abhängt, stellt dieser ein Belastungskriterium für die einzelnen Ausgangskreise dar. Der Nachteil dieser Methode ist jedoch, daß die Spannungsausgänge nicht unabhängig voneinander überwacht sind. Wird beispielsweise der Primärstrom daraufhin überwacht, daß ein einzelner Ausgangskreis die vorgeschriebene zulässige Maximalleistung nicht überschreitet, werden bereits dann Maßnahmen zur Begrenzung des Ausgangsstromes des betreffenden Ausgangskreises ergriffen, z.B. Abschalten der Stromversorgung, wenn die Summenbelastung der Ausgangskreise höher ist als die maximal zulässige Ausgangsleistung des einzelnen betreffenden Ausgangskreises, der im Augenblick vielleicht nur gering belastet ist. Andererseits kann ein einzelner Ausgangskreis seine zulässige maximale Ausgangsleistung dann überschreiten, wenn der Primärstrom auf eine Summenbelastung der Ausgangskreise hin überwacht wird, die einzelnen maximalen Ausgangsleistungen aber geringer veranschlagt sind.

Bevorzugt wird deshalb, die Ausgangsströme der Ausgangskreise einzeln zu erfassen und zu überwachen. Hierzu wird zur Zeit in jeden Ausgangskreis der Stromversorgung ein Shunt-Widerstand eingebaut, der den Ausgangsstrom des jeweils betreffenden Ausgangskreises in eine proportionale Spannung umwandelt. Überschreitet eine dieser proportionalen Spannungen eine jeweils zugehörige Grenzspannung, wird die Stromversorgung abgeschaltet.

Ein Beispiel für die Verwendung von Shunt-Widerständen in einem Schaltnetzteil zu diesem Zweck ist in der DE-Z: Elektronik 9/27.04.1990, Seite 159, Bild 2 angegeben. Der Shunt-Widerstand wird hier durch den Widerstand R1 gebildet. Zwar weist dieses Schaltnetzteil nur einen Ausgangskreis auf, doch ist klar, daß dieses Prinzip auch für weitere Ausgangskreise angewendet werden kann.

Shunt-Widerstände sind in der Regel niederohmige Bauteile. Zur Sicherstellung eines genügend großen Spannungsabfalls, der zur Auswertung herangezogen werden kann und nicht durch einen eventuell überlagerten Störpegel unbrauchbar wird, ist es notwendig, daß der betreffende Widerstand ausreichend groß gewählt ist. Bei den teils sehr hohen Strömen, die in den Ausgangskreisen fließen, beispielsweise 40 Ampere im 5 Volt Ausgangskreis, erzeugen die Shunt-Widerstände große Wärmeverluste. Wegen der Erwärmung müssen teure Hochleistungswiderstände verwendet werden. Hierfür kommen Keramik- oder Drahtwiderstände in Frage. Drahtwiderstände, die sich an sich weniger erwärmen, haben den Nachteil, daß sie eine Induktivität aufweisen, durch die das Nutzsignal leicht von Störpegeln überlagert wird.

Aufgabe der Erfindung ist es nun, ein Schaltnetzteil mit n einzeln strombegrenzten Ausgangskreisen anzugeben, dessen Einrichtung zur Überwachung der in den einzelnen Ausgangskreisen fließenden Ströme mit möglichst einfachen und verlustarm arbeitenden Bauteilen realisiert werden kann.

Diese Aufgabe wird durch die im Anspruch 1 gekennzeichneten Merkmale gelöst.

Das erfindungsgemäße Schaltnetzteil zeichnet sich dadurch aus, daß die teuren Hochleistungswiderstände zur Erfassung der Strome in den einzelnen Ausgangskreisen entfallen. Das hat den Vorteil, daß die durch die Hochleistungswiderstände bedingten Wärmeverluste ebenfalls entfallen. Die zur Erfassung der Ströme der Ausgangskreise verwendeten Bauteile sind einfach und verursachen keine neuen Wärmeverluste. Der Grundgedanke der Erfindung, einen der Ströme der Ausgangskreise nicht direkt sondern unter Berücksichtigung des Primärstromes des Schaltnetzteils durch eine Berechnung zu erfassen, hat den Vorteil, daß gerade der größte Aufwand der zur Überwachung des Ausgangskreises mit dem größten Ausgangsstrom betrieben werden muß, eingespart wird.

Vorteilhafte Ausgestaltungen der Erfindung sind in den Unteransprüchen gekennzeichnet. Eine dabei verwendete Auswerteschaltung läßt sich sehr einfach realisieren, weil ihr Aufbau sehr einfach ist.

Nachfolgend wird ein Ausführungsbeispiel der Erfindung anhand einer Zeichnung näher erläutert. Darin zeigt:
FIG 1 eine Grundschaltung eines Schaltnetzteils gemäß der Erfindung in Prinzipdarstellung,
FIG 2 ein Detailschaltbild einer in FIG 1 verwendeten Gleichrichterschaltung,
FIG 3 ein Detailschaltbild einer in FIG 1 verwendeten Siebschaltung,
FIG 4 ein Detailschaltbild einer in FIG 1 verwendeten Stromwandlerschaltung und
FIG 5 eine Auswerteschaltung zur Grundschaltung nach FIG 1.

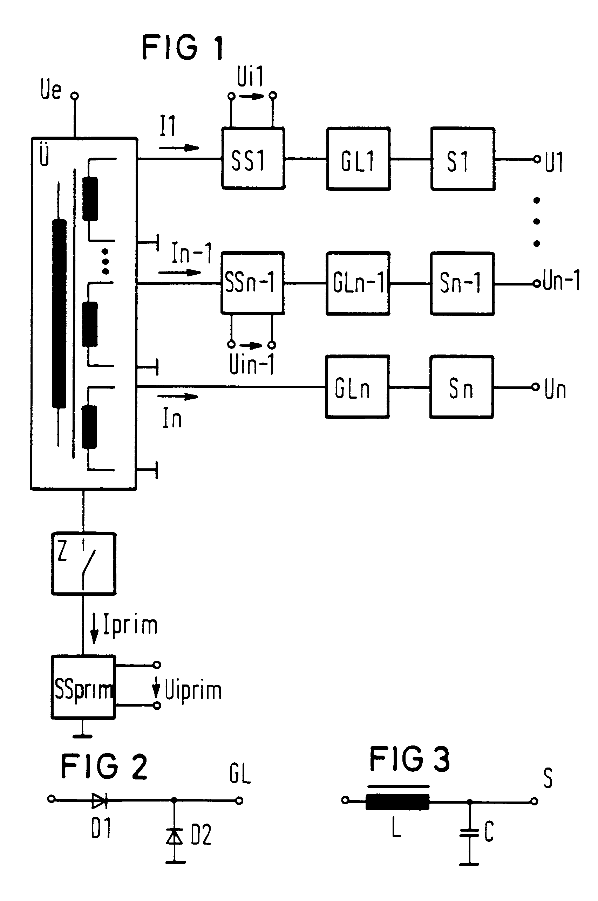

Das in FIG 1 gezeigte Schaltnetzteil arbeitet nach dem Durchflußwandlerprinzip und weist n Ausgangskreise für die Ausgangsspannungen U1 bis Un auf. Bestandteile des Schaltnetzteils sind ein Übertrager Ü, ein Zerhacker Z, eine primäre Stromwandlerschaltung SSprim und mehrere Ausgangskreise, die jeweils als Pfad an den Übertrager Ü angeschlossen sind. Der Übertrager Ü weist eine Primärwicklung und für jeden Ausgangskreis eine gesonderte Sekundärwicklung auf. Der Übertrager Ü ist primärseitig an eine Eingangsgleichspannung Ue angeschlossen, die durch den Zerhacker Z so verändert wird, daß sie auf die Sekundärseite des Übertragers Ü wirken kann. Die Eingangsgleichspannung Ue ist auf Masse bezogen. Der Zerhacker Z weist beispielsweise zur Primärwicklung in Reihe geschaltete Schalttransistoren auf, durch die zeitabhängig die Eingangsgleichspannung Ue an die Primärwicklung des Übertragers Ü angelegt wird.

Die Primärwicklung des Übertragers Ü, der Zerhacker Z und die primäre Stromwandlerschaltung SSprim bilden den Primärstromkreis des Schaltnetzteils. Im Primärstromkreis fließt ein Summenstrom Iprim, der von der Gesamtbelastung aller Ausgangskreise abhängt. Die Einzelbelastungen der Ausgangskreise drücken sich in den Strömen I1 bis In der einzelnen Ausgangskreise aus.

Der erste Ausgangskreis besteht aus einer ersten Stromwandlerschaltung SS1, einer ersten Gleichrichterschaltung GL1 sowie einer ersten Siebschaltung S1. Die Stromwandlerschaltung SS1 ist zwischen die, dem ersten Ausgangskreis zugeordneten Sekundärwicklung des Übertragers Ü und die Gleichrichterschaltung GL1 geschaltet. Die Siebschaltung S1 ist der Gleichrichterschaltung GL1 nachgeschaltet. Am Ausgang der Gleichrichterschaltung GL1 liegt die Ausgangsspannung U1 an.

Die weiteren Ausgangskreise sind bis zum (n-1)ten Ausgangskreis, der aus der (n-1)ten Stromwandlerschaltung SSn-1, der (n-1)ten Gleichrichterschaltung GLn-1 und der (n-1)ten Siebschaltung Sn-1 besteht, jeweils analog aufgebaut. Der n-te Ausgangskreis weist dagegen nur eine n-te Gleichrichterschaltung GLn und eine n-te Siebschaltung Sn auf.

Der Aufbau einer Gleichrichterschaltung GL und einer Siebschaltung S, die prinzipiell für alle n Ausgangskreise gleich ist, ist in den FIG 2 und 3 angegeben. Gemäß FIG 2 besteht eine Gleichrichterschaltung GL aus zwei Dioden D1 und D2, von denen die erste D1 in einem Längszweig und die zweite D2 in einem Querzweig angeordnet ist. Der Längs- und der Querzweig sind auf einen Punkt zusammengeschaltet. Die beiden Dioden D1 und D2 sind so angeordnet, daß ihre Kathoden auf den Zusammenschaltungspunkt der beiden Zweige weisen. Die Anode der im Querzweig angeordneten Diode D2 ist mit Masse verbunden, während die Anode der im Längszweig angeordneten Diode D1 mit dem Eingang der Gleichrichterschaltung GL verbunden ist. Der Zusammenschaltungspunkt des Längs- und Querzweiges bildet den Ausgang der Gleichrichterschaltung.

Gemäß FIG 3 besteht eine Siebschaltung S aus einer Induktivität L und einer Kapazität C. Die Induktivität L ist in einem Längszweig und die Kapazität in einem Querzweig der Siebschaltung S angeordnet. Der Längs- und der Querzweig sind auf einen Punkt zusammengeschaltet, wobei der Zusammenschaltungspunkt den Ausgang der Siebschaltung S bildet. Das freie Ende der Induktivität L ist mit dem Eingang der Siebschaltung S und das freie Ende der Kapzität mit der Masse verbunden.

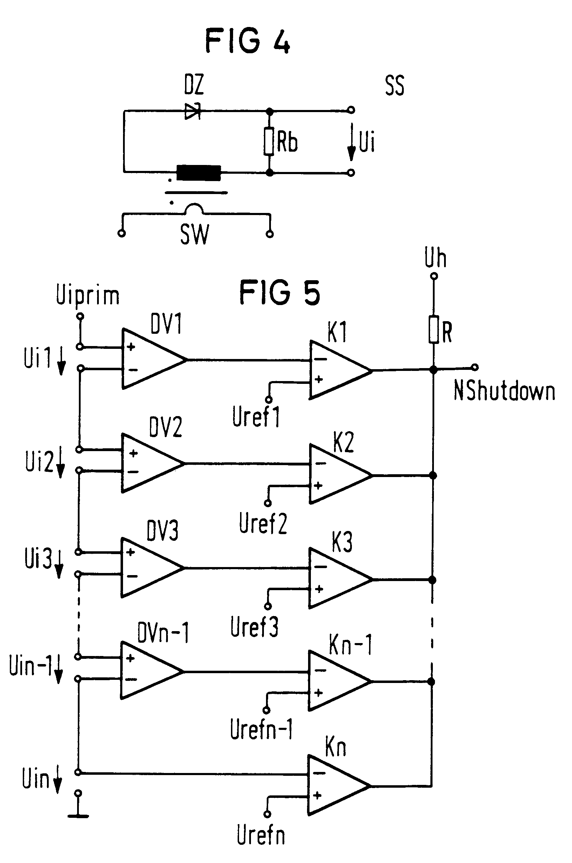

Der Aufbau einer Stromwandlerschaltung SS ist in der FIG 4 angegeben. Die Stromwandlerschaltungen SS sind sowohl für den Primärstromkreis als auch für die einzelnen Ausgangskreise jeweils gleich. Für den Primärstromkreis können die Bezugszeichen der einzelnen Bauteile mit dem Zusatz prim versehen und für die einzelnen Ausgangskreise mit einer Zahl von 1 bis (n-1) versehen aufgefaßt werden.

Eine Stromwandlerschaltung SS besteht aus einem Stromwandler SW, einer Zenerdiode DZ und einem Widerstand Rb. Der Stromwandler SW ist ein an sich bekanntes Bauteil. Er weist einen Ringkern mit einer einzigen Windung auf der Primärseite und relativ wenigen Windungen, z.B. 100, auf der Sekundärseite auf. Die Primärwicklung wird durch einen relativ sehr dicken Draht gebildet, damit über sie der jeweilige Strom praktisch verlustfrei fließen kann. Stromwandler sind einfache Bauteile und daher kostengünstig.

Die Primärwicklung des Stromwandlers SW ist in Reihe in den jeweiligen Stromkreis geschaltet, so daß der betreffende Strom über die Primärwicklung fließt. Bezüglich des Primärstromkreises ist das der Strom Iprim und bezüglich der Ausgangskreise sind das die Ströme I1 bis In-1.

Ein Ende der Sekundärwicklung des Stromwandlers SW ist mit der Anode der Zenerdiode DZ verbunden. Das andere Ende der Sekundärwicklung des Stromwandlers SW ist mit einem ersten Ausgangsanschluß und gleichzeitig mit einer Seite des Widerstandes Rb der Stromwandlerschaltung SS verbunden. Die Kathode der Zenerdiode DZ ist mit der anderen Seite des Widerstandes Rb und gleichzeitig mit einem zweiten Ausgangsanschluß der Stromwandlerschaltung SS verbunden. Neben dem Übersetzungsverhältnis des Stromwandlers SW ist die Größe des Widerstandes Rb dafür maßgebend, welche Ausgangsspannung Ui zwischen den Ausgangsanschlüssen der Stromwandlerschaltung SS erzeugt wird. Bei den ersten (n-1) Ausgangskreisen erzeugt die jeweilige Stromwandlerschaltung SS1 bis SSn-1 jeweils eine potentialfreie Proportionalspannung Ui1 bis Uin-1 als Ausgangsspannung Ui. Bei der primären Stromwandlerschaltung SSprim ist diejenige Seite der Sekundärwicklung des Stromwandlers SW, die mit dem Widerstand Rb verbunden ist, auf Masse gelegt, so daß die hier erzeugte Ausgangsspannung Uiprim auf Masse bezogen ist. Da sich die Ausgangsspannungen Ui proportional zum durch die Primärwicklung des Stromwandlers SW fließenden Stromes ändert, werden diese Spannungen als Proportionalspannungen bezeichnet.

Gemäß dem Ausführungsbeispiel nach FIG 1 ist für den n-ten Ausgangskreis des Schaltnetzteils kein Stromwandler vorgesehen.

Zur Grundschaltung gemäß FIG 1 des Schaltnetztteils gehört eine Auswerteschaltung, die in FIG 5 angegeben ist. Die Auswerteschaltung weist (n-1) Differenzverstärker DV1 bis DVn-1 und n Komparatoren K1 bis Kn auf. Den ersten (n-1) Ausgangskreisen sind jeweils ein Differenzverstärker DV und ein Komparator K zugeordnet. Dem n-ten Ausgangskreis ist nur ein Komparator Kn zugeordnet. Sowohl die Differenzverstärker DV als auch die Komparatoren K weisen jeweils einen positiven und einen negativen Eingang auf. Die ersten (n-1) Komparatoren K1 bis Kn-1 sind den jeweils gleich nummerierten Differenzverstärkern DV1 bis DVn-1 nachgeschaltet. Dabei ist jeweils der Ausgang eines Differenzverstärkers DV mit dem negativen Eingang eines Komparators K verbunden.

An den jeweiligen positiven Eingängen der Komparatoren K1 bis Kn-1 sind Grenzspannungen Uref1 bis Urefn-1 angeschlossen. Am entsprechenden Eingang des n-ten Komparators Kn ist die Grenzspannung Urefn angeschlossen. Die Eingänge der Differenzverstärker DV1 bis DVn-1 sind so geschaltet, daß jeweils der positive Eingang eines Differenzverstärkers DV mit dem negativen Eingang eines anderen Differenzverstärkers DV zusammengeschaltet sind. Insgesamt ergibt sich über die jeweiligen Eingänge der Differenzverstärker DV1 bis DVn-1 eine Nebeneinanderschaltung der Differenzverstärker DV. Am freien positiven Eingang des am einen Ende der Nebeneinanderschaltung liegenden Differenzverstärkers DV, im Ausführungsbeispiel DV1, ist die Proportionalspannung Uiprim des Primärstromkreises angeschlossen. Der freie negative Eingang des am anderen Ende der Nebeneinanderschaltung liegenden Differenzverstärkers DV, im Ausführungsbeispiel DVn-1, ist mit dem negativen Eingang des n-ten Komparators Kn verbunden.

Zwischen einem positiven und einem negativen Eingang eines Differenzverstärkers DV sind mit Bezug auf den negativen Eingang jeweils eine der in der Grundschaltung erzeugten Proportionalspannungen Ui angelegt. Im einzelnen ist zwischen den Eingängen des ersten Differenzverstärkers DV1 die Proportionalspannung Ui1, zwischen den Eingängen des zweiten Differenzverstärkers DV2 die Proportionalspannung Ui2 usw. angelegt, bis zum (n-1)ten Differenzverstärker DVn-1, zwischen dessen Eingängen die Proportionalspannung Uin-1 angelegt ist.

Die Komparatoren K1 bis Kn weisen jeweils einen Open-Kollektor-Ausgang auf, die untereinander zusammengeschaltet sind. Die zusammengeschalteten Ausgänge der Komparatoren K sind mit dem Ausgang der Auswerteschaltung verbunden, an dem das Steuersignal NShutdown erzeugt wird. Über einen Widerstand R sind die zusammengeschalteten Ausgänge der Komparatoren K mit einer Hilfsspannung Uh verbunden. Durch die Hilfsspannung Uh wird das Steuersignal NShutdown im inaktiven Zustand auf ein Potential der Größe Uh gelegt. Im aktiven Zustand wird das Potential dieses Ausgangs durch einen der Komparatoren K auf Null gesetzt. Mittels des Steuersignals NShutdown wird die Überlastung eines der Ausgangskreise sichtbar gemacht. Eine Überlastung wird dann erkannt, wenn wenigstens eine der Proportionalspannungen Ui1 bis Uin-1 größer ist als die jeweils einem entsprechenden Komparator K1 bis Kn zugeordnete Grenzspannung Uref1 bis Urefn. Die Komparatoren K1 bis Kn führen die jeweiligen Vergleiche durch.

Die Auswerteschaltung gemäß FIG 5 führt insgesamt eine arithmetische Berechnung der Proportionalspannung Uin durch, die am negativen Eingang des (n-1)ten Differenzverstärkers DVn-1 bzw. am negativen Eingang des n-ten Komparators Kn jeweils bezogen auf Masse entsteht. Die gesuchte Proportionalspannung Ui ergibt sich aus der Differenz des Gesamtstroms, der sich in der Proportionalspannung Uiprim des Primärstromkreises ausdrückt, minus der in den Ausgangskreisen fließenden Ströme, die sich in den Proportionalspannungen Ui1 bis Uin-1 ausdrücken.

## Patentansprüche

1. Schaltnetzteil mit n einzeln strombegrenzten Ausgangskreisen, das einen Übertrager (Ü) zur Energieversorgung der einzelnen Ausgangskreise aufweist, zu denen jeweils eine wenigstens anteilig vorhandene Sekundärwicklung des Übertragers sowie eine der Sekundärwicklung nachgeschaltete Gleichrichterschaltung (GL1-GLn) und, daran angeschlossen, eine Siebschaltung (S1-Sn) gehört, **dadurch gekennzeichnet,** daß bei (n-1) Ausgangskreisen zwischen der Sekundärwicklung und der Gleichrichterschaltung (GL) sowie im Primärstromkreis jeweils ein Stromwandler (SW) vorgesehen ist, der als Teil je einer Stromwandlerschaltung (SS bzw. SSprim) mit wenigstens einem Ausgang entweder für eine Proportionalspannung (Ui), wenn die betreffende Stromwandlerschaltung (SS) einem der (n-1) Ausgangskreise zugeordnet ist, oder für eine Proportionalspannung (Uiprim), wenn die betreffende Stromwandlerschaltung (SSprim) dem Primärstromkreis zugeordnet ist, mit einer gemeinsamen Auswerteschaltung verbunden ist, die sowohl weitere Eingänge für die einzelnen, auf die (n-1) Ausgangskreise bezogenen Proportionalspannungen (Ui) zugeordneten Grenzspannungen (Uref) als auch einen weiteren Eingang für eine zusätzliche Grenzspannung (Urefn) sowie einen Ausgang für ein Steuersignal NShutdown aufweist, das von der gemeinsamen Auswerteschaltung dann gesetzt wird, wenn entweder eine der auf die (n-1) Ausgangskreise bezogenen Proportionalspannungen (Ui) die jeweils zugehörige Grenzspannung (Uref) oder eine, aus der auf den Primärstromkreis bezogenen Proportionalspannung (Uiprim) und der Summenspannung der auf die (n-1) Ausgangskreise bezogenen Proportionalspannungen (Ui) gebildete Differenzspannung (Uin) die zusätzliche Grenzspannung (Urefn) überschreitet.

2. Schaltungsanordnung nach Anspruch 1, **dadurch** **gekennzeichnet,** daß diejenigen Stromwandlerschaltungen (SS), zu denen die auf die (n-1) Ausgangskreise bezogenen Stromwandler (SW) gehören, jeweils zwei Ausgänge für eine jeweils potentialfreie Proportionalspannung (Ui) aufweisen.

3. Schaltungsanordnung nach Anspruch 2, **dadurch** **gekennzeichnet,** daß die gemeinsame Auswerteschaltung für jede der auf die (n-1) Ausgangskreise bezogenen Proportionalspannungen (Ui) einen Differenzverstärker (DV) und diesem jeweils nachfolgend einen Komparator (K) aufweist, der jeweils auf die, der jeweils betreffenden Proportionalspannung (Ui) zugeordneten Grenzspannung (Uref) bezogen geschaltet ist, daß ein weiterer Komparator (Kn) vorgesehen ist, der eingangsseitig mit einem Eingang auf die Differenzspannung (Uin) und mit einem anderen Eingang auf die, der Differenzspannung (Uin) zugeordneten Grenzspannung (Uirefn) bezogen geschaltet ist, daß die einzelnen Komparatoren (K bzw. Kn) ausgangsseitig mit dem Ausgang für das Steuersignal NShutdown der gemeinsamen Auswerteschaltung verbunden sind und daß der Ausgang für das Steuersignal NShutdown über einen Widerstand (R) auf eine Hilfsspannung (Uh) bezogen, geschaltet ist.

4. Schaltungsanordnung nach Anspruch 3, **dadurch** **gekennzeichnet,** daß die Differenzverstärker (DV) jeweils einen positiven und einen negativen Eingang aufweisen, von denen jeweils der positive Eingang eines Differenzverstärkers (z.B. DV2) mit dem negativen Eingang eines anderen Differenzverstärkers (z.B. DV1) verbunden sind, so daß die Differenzverstärker (DV) über deren jeweilige Eingänge nebeneinandergeschaltet sind, daß auf den freien positiven Eingang des an dem einen Ende der so gebildeten Nebeneinanderschaltung der Differenzverstärker (DV) liegenden Differenzverstärkers (z.B. DV1) die auf den Primärstromkreis bezogene Proportionalspannung (Uiprim) geschaltet und der freie negative Eingang des am anderen Ende der so gebildeten Nebeneinanderschaltung der Differenzverstärker (DV) liegenden Differenzverstärkers (z.B. DVn-1) mit dem, auf die Differenzspannung (Uin) bezogen geschalteten Eingang des weiteren Komparators (Kn) verbunden ist.

5. Schaltungsanordnung nach Anspruch 4, **dadurch** **gekennzeichnet,** daß die mit dem Primärstromkreis in Verbindung stehende Proportionalspannung (Uiprim) und die Differenzspannung (Uin) jeweils auf Masse bezogen geschaltet sind.

## Claims

1. Switched-mode power supply with n individual current-limited output circuits, which has a transformer (Ü) for the power supply for the individual output circuits, to which there belongs in each case a secondary winding, present at least proportionally, of the transformer as well as a rectifier circuit (GL1-GLn) connected downstream of the secondary winding and, connected to said rectifier circuit, a filter circuit (S1-Sn), characterized in that in (n-1) output circuits between the secondary winding and the rectifier circuit (GL) as well as in the primary circuit, provision is made in each case of a current transformer (SW) which, as part of in each case one current transformer circuit (SS and SSprim, respectively), is connected with at least one output either for a proportional voltage (Ui), when the relevant current transformer circuit (SS) is assigned to one of the (n-1) output circuits, or for a proportional voltage (Uiprim), when the relevant current transformer circuit (SSprim) is assigned to the primary circuit, to a common evaluation circuit which has both further inputs for the limiting voltages (Uref) assigned to the individual proportional voltages (Ui) referred to the (n-1) output circuits and a further input for an additional limiting voltage (Urefn) as well as an output for a control signal NShutdown which is set by the common evaluation circuit when either one of the proportional voltages (Ui) referred to the (n-1) output circuits overshoots the respectively associated limiting voltage (Uref), or a difference voltage (Uin) formed from the proportional voltage (Uiprim) referred to the primary circuit and the total voltage of the proportional voltages (Ui) referred to the (n-1) output circuits overshoots the additional limiting voltage (Urefn).

2. Circuit arrangement according to Claim 1, characterized in that those current transformer circuits (SS) to which the current transformers (SW) referred to the (n-1) output circuits belong in each case have two outputs for a proportional voltage (Ui) which is potential-free in each case.

3. Circuit arrangement according to Claim 2, characterized in that for each of the proportional voltages (Ui) referred to the (n-1) output circuits the common evaluation circuit has a differential amplifier (DV) and, downstream thereof in each case, a comparator (K) which is connected in a manner referred in each case to the limiting voltage (Uref) assigned to the respectively relevant proportional voltage (Ui), in that a further comparator (Kn) is provided which is connected on the input side with one input in a manner referred to the difference voltage (Uin) and with another input in a manner referred to the limiting voltage (Uirefn) assigned to the difference voltage (Uin), in that the individual comparators (K and Kn, respectively) are connected on the output side to the output for the control signal NShutdown of the common evaluation circuit, and in that the output for the control signal NShutdown is connected via a resistor (R) in a manner referred to an auxiliary supply (Uh).

4. Circuit arrangement according to Claim 3, characterized in that the differential amplifiers (DV) in each case have a positive and a negative input, of which in each the positive input of one differential amplifier (for example DV2) is connected to the negative input of another differential amplifier (for example DV1), so that the differential amplifiers (DV) are connected in parallel via their respective inputs, and in that the proportional voltage (Uiprim) referred to the primary circuit is connected to the free positive input of the differential amplifier (for example DV1) situated at one end of the parallel circuit of the differential amplifier (DV) thus formed, and the free negative input of the differential amplifier (for example DVn-1) situated at the other end of the parallel circuit of the differential amplifier (DV) thus formed is connected to the input, connected in a manner referred to the differential voltage (Uin), of the further comparator (Kn).

5. Circuit arrangement according to Claim 4, characterized in that the proportional voltage (Uiprim) connected to the primary circuit and the difference voltage (Uin) are in each case connected in a manner referred to earth.

## Revendications

1. Elément de réseau ou bloc d'alimentation commuté comportant n circuits de sortie limités individuellement en courant, et comportant un transformateur (Ü) servant à réaliser l'alimentation en énergie des différents circuits de sortie, dont font partie respectivement un enroulement secondaire, au moins présent pour une partie du transformateur ainsi qu'un circuit redresseur (GL1-GLn) branché en aval de l'enroulement secondaire, et un circuit de lissage (51-5n) raccordé à ce circuit, caractérisé par le fait que dans le cas de (n-1) circuits de sortie entre l'enroulement secondaire et le circuit redresseur (GL) ainsi que dans le circuit à courant primaire il est prévu respectivement un transformateur d'intensité (SW), qui, en tant que partie d'un circuit transformateur d'intensité respectif (SS ou SSprim) est raccordé, par au moins une sortie, soit pour une tension proportionnelle (Ui), lorsque le circuit considéré (SS) du transformateur d'intensité est associé à l'un des (n-1) circuits de sortie, soit pour une tension proportionnelle (Uiprim) lorsque le circuit considéré (SSprim) du transformateur d'intensité est associé au circuit primaire, à un circuit d'évaluation commun qui possède aussi bien d'autres entrées pour les tensions limites (Uref) associées à différentes tensions proportionnelles (Ui) rapportées aux (n-1) circuits en sortie, qu'ainsi, une autre entrée pour une tension limite supplémentaire (Urefn) ainsi qu'une sortie pour un signal de commande NShutdown, qui est positionné par le circuit d'évaluation commun lorsque soit l'une des tensions proportionnelles (Ui) rapportées aux (n-1) circuits de sortie dépasse la tension limite respective associée (Uref), soit une tension différentielle (Uin), formée à partir de la tension proportionnelle (Uiprim), rapportée au circuit primaire, et de la somme des tensions proportionnelles (Ui) rapportée aux (n-1) circuits de sortie, dépasse la tension limite supplémentaire (Urefn).

2. Montage suivant la revendication 1, caractérisé par le fait que les circuits formant transformateur d'intensité (SS), dont font partie les transformateurs d'intensité (SW) rapportés aux (n-1) circuits de sortie, comportent chacun deux sorties pour respectivement une tension proportionnelle (Ui) à potentiel libre.

3. Montage suivant la revendication 2, caractérisé par le fait que le circuit d'évaluation commun comporte, pour chacune des tensions proportionnelles (Ui) rapportées aux (n-1) circuits de sortie, un amplificateur différentiel (DV) et, respectivement en aval de ce dernier, un comparateur (K), qui est raccordé respectivement à la tension limite (Uref) associée à la tension proportionnelle respectivement considérée (Ui), qu'il est prévu un autre comparateur (Kn), qui est raccordé côté entrée, par une entrée, à la tension différentielle (Uin) et à une autre entrée, à la tension limite (Uirefn) associée à la tension différentielle (Uin), que les différents comparateurs (K ou Kn) sont raccordés côté sortie à la sortie du signal de commande NShutdown du circuit d'évaluation commun et que la sortie pour le signal de commande NShutdown est raccordée par l'intermédiaire d'une résistance (R) à une tension auxiliaire (Uh).

4. Montage suivant la revendication 3, caractérisé par le fait que les amplificateurs différentiels (DV) possèdent chacun une entrée positive et une entrée négative, parmi lesquelles respectivement l'entrée positive d'un amplificateur différentiel (par exemple DV2) est raccordée à l'entrée négative d'un autre amplificateur différentiel (par exemple DV1), de sorte que les amplificateurs différentiels (DV2) sont branchés en série par l'intermédiaire de leurs entrées respectives, que la tension proportionnelle (Uiprim) rapportée au circuit primaire est appliquée à l'entrée positive libre de l'amplificateur différentiel (par exemple DV1), qui est situé à une extrémité du circuit parallèle ainsi formé des amplificateurs différentiels (DV), et que l'entrée négative libre de l'amplificateur différentiel (par exemple DVn-1), qui est situé à l'autre extrémité du circuit parallèle ainsi formé des amplificateurs différentiels (DV) est reliée à l'entrée, raccordée à la tension différentielle (Uin), de l'autre comparateur (Kn).

5. Montage suivant la revendication 5, caractérisé par le fait que la tension proportionnelle (Uiprim), qui est reliée au circuit primaire, et la tension différentielle (Uin) sont appliquées respectivement par rapport à la masse.
